# EUROPÄISCHE PATENTSCHRIFT

(11) **EP 1 227 529 B1**
(45) Veröffentlichungstag und Bekanntmachung des Hinweises auf die Patenterteilung: **31.12.2008**
(21) Anmeldenummer: 02000231.7
(22) Anmeldetag: 14.01.2002
(51) Int. Cl.: H01L 51/50, C08G 61/12

(54) **Elektrolumineszierende Anordnungen**
Electroluminescent devices
Dispositifs électroluminescents

(30) Priorität: 26.01.2001 DE 10103416
(43) Veröffentlichungstag der Anmeldung: 31.07.2002
(73) Patentinhaber: H.C. Starck GmbH, 38642 Goslar (DE)
(72) Erfinder: Jonas, Friedrich, Dr., 52066 Aachen (DE); Elschner, Andreas, Dr., 45479 Mülheim (DE); Wussow, Klaus, Dr., 57250 Netphen (DE); Wehrmann, Rolf, Dr., 47800 Krefeld (DE)
(74) Vertreter: Clauswitz, Kai-Uwe Wolfram

(56) Entgegenhaltungen:
- EP-A- 0 553 502
- EP-A- 0 991 303
- US-A- 5 567 355

## Beschreibung

Die Erfindung betrifft elektrolumineszierende Anordnungen, die als Hilfsschichten leitfähige Polymere, speziell 3,4-Polyalkylendioxythiophene enthalten und 3,4-Polyalkylendioxythiophendispersionen.

Eine elektrolumineszierende (EL) Anordnung ist dadurch charakterisiert, dass sie bei Anlegung einer elektrischen Spannung unter Stromfluss Licht aussendet. Derartige Anordnungen sind unter der Bezeichnung "Leuchtdioden" (LEDs = "light emitting diodes") seit langem bekannt. Die Emission von Licht kommt dadurch zustande, dass positive Ladungen (Löcher, "holes") und negative Ladungen (Elektronen, "electrons") unter Aussendung von Licht rekombinieren.

Die in der Technik gebräuchlichen LEDs bestehen alle zum überwiegenden Teil aus anorganischen Halbleitermaterialien. Seit einigen Jahren sind jedoch EL-Anordnungen bekannt, deren wesentliche Bestandteile organische Materialien sind.

Diese organischen EL-Anordnungen enthalten in der Regel eine oder mehrere Schichten aus organischen Ladungstransportverbindungen.

Der prinzipielle Schichtaufbau ist wie folgt:
- 1: Träger, Substrat
- 2: Basiselektrode
- 3: Löcher-injizierende Schicht
- 4: Löcher-transportierende Schicht
- 5: Emitter-Schicht
- 6: Elektronen-transportierende Schicht
- 7: Elektronen-injizierende Schicht
- 8: Topelektrode
- 9: Kontakte
- 10: Umhüllung, Verkapselung

Dieser Aufbau stellt den allgemeinsten Fall dar und kann vereinfacht werden, indem einzelne Schichten weggelassen werden, so dass eine Schicht mehrere Aufgaben übernimmt. Im einfachsten Fall besteht eine EL-Anordnung aus zwei Elektroden, zwischen denen sich eine organische Schicht befindet, die alle Funktionen - inklusive der der Emission von Licht - erfüllt. Derartige Systeme sind z. B. in WO 90/13148 auf der Basis von Poly-[p-phenylenvinylen] beschrieben.

Bei der Herstellung von großflächigen, elektrolumineszierenden Anzeigeelementen muss mindestens eine der stromzuführenden Elektroden 2 oder 8 aus einem transparenten und leitfähigem Material bestehen.

Als Substrat 1 sind transparente Träger wie Glas oder Kunststoff-Folien (z.B. Polyester, wie Polyethylenterephthalat oder Polyethylennaphthalat, Polycarbonat, Polyacrylat, Polysulfon, Polyimid-Folie) geeignet.

Als transparente und leitfähige Elektroden-Materialien sind geeignet:
a) Metalloxide, z.B. Indium-Zinn-Oxid (ITO), Zinnoxid (NESA) etc.,
b) semi-tranparente Metallfilme, z.B. Au, Pt, Ag, Cu etc..

Geeignete Emitterschichten 5 sind z.B. in DE-A 196 27 071 beschrieben.

Es hat sich aber in der Praxis gezeigt, dass zur Erhöhung der Leuchtdichte elektronen- bzw. lochinjizierende Schichten (3,4 und/oder 6,7) in die elektrolumineszierenden Aufbauten eingebaut werden müssen.

Aus der EP-A 686 662 ist bekannt, spezielle Mischungen aus leitfähigen organischen polymeren Leitern wie 3,4-Polyethylendioxythiophen und Polyhydroxyverbindungen oder Lactamen als Elektrode 2 in Elektrolumineszenzanzeigen einzusetzen. Es hat sich aber in der Praxis gezeigt, dass diese Elektroden besonders für großflächige Anzeigen eine nicht ausreichende Leitfähigkeit aufweisen. Für kleine Anzeigen (Pixelgröße < 1mm²) reicht die Leitfähigkeit dagegen aus.

Aus der DE-A 196 27 071 ist bekannt, polymere organische Leiter z.B. 3,4-Polyethylendioxythiophen als lochinjizierende Schichten einzusetzen. Hierdurch kann die Leuchtstärke der elektrolumineszierenden Anzeigen gegenüber Aufbauten ohne den Einsatz polymerer organischer Zwischenschichten deutlich gesteigert werden. Die Lebensdauer dieser Anzeigen ist aber für praktische Anwendungen immer noch nicht ausreichend.

Aus der EP-A 991 303 sind 3,4-Polyalkylendioxythiophene mit Teilchengrößen < 250 nm und Leitfähigkeiten der getrockneten Polymere von < 2 S/cm entsprechend einem spezifischen Widerstand von 0,5 Ωcm bekannt. Für die Anwendung in Passiv Matrix Displays sind diese 3,4-Polyalkylendioxythiophene aber immer noch zu leitfähig. Durch die hohe Leitfähigkeit kommt es zum sogenannten "Cross Talk" zwischen benachbarten Leiterbahnen (s. z.B. D. Braun in Synth. Metals, 92 (1998) 107-113).

Überraschenderweise wurde jetzt gefunden, dass durch weitere Verkleinerung der Teilchen der Widerstand der in der EP-A 991 303 beschriebenen 3,4-Polyalkylendioxythiophene deutlich erhöht werden kann, ohne dass die gewünschte lochinjizierende Wirkung verloren geht.

Gegenstand der Erfindung sind daher 3,4-Polyalkylendioxythiophendispersionen in denen mindestens 90 Gew.-% der Teilchen < 50 nm sind und vorzugsweise der spezifische Widerstand von daraus hergestellten Beschichtungen > 5000 Ωcm ist. Bevorzugt sind Dispersionen in denen mindestens 90 Gew-% der Teilchen < 40 nm sind.

Gegenstand der Erfindung sind weiterhin elektrolumineszierende Anordnungen, die eine lochinjizierende Schicht enthalten, die aus einer erfindungsgemäßen Dispersion hergestellt wurde.

Die Teilchengröße wurde im gequollenen Zustand mittels Ultrazentrifuge bestimmt. Das allgemeine Vorgehen ist im Colloid Polym. Sci. 267, 1113 bis 1116 (1989) beschrieben. Die Herstellung dieser Dispersionen erfolgte ausgehend von Dispersionen nach EP-A 991 303 durch anschließende Zerkleinerung der Teilchen.

Geeignete Zerkleinerungsverfahren sind z.B. Mahlung mittels Kugelmühlen oder Rührwerksmühlen, Hochgeschwindigkeitsrühren, Behandlung mittels Ultraschall und Hochdruckhomogenisierung.

Bevorzugt ist die Hochdruckhomogenisierung, bei der die Dispersion ein oder mehrstufig unter hohem Druck durch Metall oder Keramikdüsen gepresst wird. Der Durchmesser der Düsen liegt zwischen 1 und 0,1 mm bzw. bei Schlitzdüsen bei einer Breite von 0,1 und 1mm. Die Homogenisierung erfolgt bei Drücken von 1 bis 2000 bar, bevorzugt von 100 bis 1000 bar.

Zur Erreichung des gewünschten Ergebnisses sind gegebenenfalls auch mehrere Durchgänge erforderlich.

Die erfindungsgemäßen Dispersionen enthalten vorzugsweise Polyanionen und kationische, lösliche oder unlösliche 3,4-Polyalkylendioxythiophene der Formel I 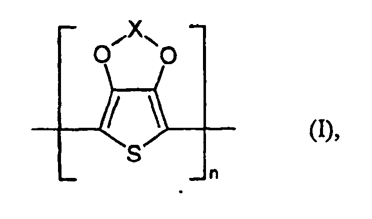 in der
- n: für eine ganze Zahl von 3 bis 100 , bevorzugt 4 bis 15 und
- X: für -(CH₂)ₓ-CR¹R²-(CH₂)_{y}- steht, wobei
- R¹, R²: unabhängig voneinander für H, einen gegebenenfalls substituierten Alkylrest mit 1 bis 20 C-Atomen, einen Arylrest mit 6 bis 14 C-Atomen oder -CH₂-OR³ mit R³ = H, Alkyl oder -CH₂-CH₂-CH₂-SO₃H und
- x, y: jeweils unabhängig voneinander für eine ganze Zahl von 0 bis 9 steht.

Entsprechende Verbindungen sind in EP-A 440 957 und DE-A 4 211 459 beschrieben.

Vorzugsweise werden die erfindungsgemäßen 3,4-Polyalkylendioxythiophen-Dispersionen vor der Beschichtung durch ein Filter filtriert.

Besonders bei Verwendung der leitfähigen Polymere der Formel I in kationischer Form in Kombination mit Polyanionen, bevorzugt Polyanionen der Polystyrolsulfonsäure, die analog EP-A 440 957 hergestellt werden können, hat es sich gezeigt, dass gut filtrierbare Dispersionen erhalten werden, wenn bezogen auf ein Gewichtsteil 3,4-Polyalkylendioxythiophen der Formel I 6 bis 30 Gewichtsteile Polyanion bevorzugt 8 bis 25 Teile Polyanion verwendet werden. Das Gewichtsverhältnis von Polykation zu Polyanion liegt also vorzugsweise zwischen 1:8 und 1:25.

Dieses Verhältnis von 3,4-Polyalkylendioxythiophen zu Polyanion kann direkt bei der Herstellung eingestellt werden. Es hat sich aber gezeigt, dass es auch möglich ist von einer Lösung oder Dispersion mit einem höheren Anteil an 3,4-Polyalkylendioxythiophen auszugehen und erst anschließend das erfindungsgemäße Verhältnis von 3,4-Polyalkylendioxythiophen zu Polyanion durch Zugabe von Polyanionen einzustellen.

Die Feststoffgehalte der erfindungsgemäßen Dispersionen liegen zwischen 0,01 und 20 Gew.-%, bevorzugt zwischen 0,2 und 5 Gew.-%.

Die Viskosität bei 20°C der Dispersionen liegt zwischen der Viskosität des reinen Wassers bzw. Lösungsmittelgemisches und 200 mPas, bevorzugt < 100 mPas.

Zur Einstellung des gewünschten Feststoffgehaltes und der erforderlichen Viskosität kann aus den wässrigen Dispersionen die gewünschte Menge Wasser durch Destillation, bevorzugt im Vakuum, oder durch andere Verfahren z.B. Ultrafiltration entfernt werden.

Erfindungsgemäße elektrolumineszierende Anordnungen enthalten eine lochinjizierende Schicht, die aus einer erfindugnsgemäßen Dispersion hergestellt wurde.

Die Herstellung der lochinjizierenden Schicht (3) erfolgt nach bekannten Technologien. Dazu wird eine erfindungsgemäße Dispersion auf einer Basiselektrode als Film verteilt. Als Lösungsmittel werden bevorzugt Wasser bzw. Wasser Alkoholgemische verwendet. Geeignete Alkohole sind z.B. Methanol, Ethanol, Propanol, Isopropanol und Butanol.

Die Verwendung dieser Lösungsmittel hat den Vorteil, dass dann weitere Schichten aus organischen Lösungsmitteln, wie aromatischen oder aliphatischen Kohlenwasserstoffgemischen aufgebracht werden können, ohne dass die Schicht (3) angegriffen wird.

Den erfindungsgemäßen Dispersionen können außerdem organische, polymere Bindemittel und/oder organische, niedermolekulare Vernetzungsmittel zugesetzt werden. Entsprechende Bindemittel sind z.B. in EP-A 564 911 beschrieben.

Die Dispersionen enthalten bevorzugt nur geringe Mengen ionischer Verunreinigungen in den Grenzen wie sie in EP-A 991 303 beschrieben sind.

Die erfindungsgemäße Dispersion kann beispielsweise durch Techniken wie Spincoaten, Casting, Rakeln, Drucken, Vorhanggießen etc. auf dem Substrat gleichmäßig verteilt werden. Anschließend können die Schichten bei Raumtemperatur oder Temperaturen bis 300°C, bevorzugt 100 bis 200°C getrocknet werden.

Die Leitfähigkeit der lochinjizierenden Schicht (3) wird bestimmt, indem der Oberflächenwiderstand der Schicht gemessen wird. Als besonders geeignet hat sich dazu folgender Versuchsaufbau erwiesen: Auf einen elektrisch isolierenden Träger, z.B. ein Glassubstrat, wird die lochinjizierende Schicht in einer Schichtdicke d von z.B. 200 nm aufgecoatet und anschließend sorgfältig bei 100 bis 300°C getrocknet. Danach werden Metallstreifen als Elektroden auf die Schicht gedampft. Gut geeignet sind Elektroden aus Gold, die in einer Aufdampfapparatur bei einem Druck von ca. 10⁻⁶ mbar mit Hilfe einer Maske als parallele Streifen aufgedampft werden. Die Streifen haben z.B. eine Länge 1 von 20 mm, eine Breite b von 3 mm und einen Abstand a von 1,0 mm. Der elektrische Widerstand R der Schicht wird zwischen zwei benachbarten Elektroden entweder in 2-Pol oder 4-Poltechnik gemessen. Um den Einfluss der Luftfeuchte auszuschließen, erfolgt die Widerstandsmessung in trockener Atmosphäre oder im Vakuum. Der Oberflächenwiderstand R□ errechnet sich entsprechend R□ = R• 1 / a, die Leitfähigkeit σ entspechend σ = 1/( R□•d) und der spezifische Widerstand R spez. entsprechend R spez. = R□•d.

Alternativ zu aufgedampften Metall-Elektroden lässt sich der Messaufbau auch mit ITO-Elektroden realisieren. Dazu wird die ITO-Schicht auf Glas strukturiert, z.B. als parallele Streifen, und die lochinjizierende Schicht wird anschließend aufgecoated. Zwischen benachbarten ITO-Elektroden wird dann, wie oben beschrieben, der Widerstand gemessen.

Um eine bestimmte Leitfähigkeit der lochinjizierenden Schicht einzustellen, wurde überraschend gefunden, dass sich dies einfach realisieren lässt, indem zwei Lösungen des lochinjizierenden Polymers im richtigen Verhältnis gemischt werden. Die eine Lösung muss dabei als Schicht eine höhere Leitfähigkeit als die gewünschte haben, die andere eine niedrigere. Die sich einstellende Leitfähigkeit des Lösungsgemischs, folgt linear aus dem Volumenanteil der beiden Einzellösungen.

Die erfindungsgemäße Dispersion kann außerdem bevorzugt durch Techniken wie Ink-Jet strukturiert aufgebracht werden. Diese Technik unter Einsatz wasserlöslicher Polythiophene wie 3,4-Polyethylendioxythiophen ist z.B. in Science, Vol. 279, 1135, 1998 und DE-A 198 41 804 beschrieben.

Bei Anwendung dieser Beschichtungstechnik werden bevorzugt Polyparaphenylenvinylenderivate und/oder Polyfluorenderivate als Emitterschicht 5 ohne Verwendung zusätzlicher lochtransportierender Schichten 4 verwendet. Es hat sich nämlich gezeigt, dass bei Verwendung von vollflächig mit Indium-Zinnoxid beschichteten Trägern auf die die leitfähige Polymerschicht strukturiert aufgebracht wurde, die anschließend ebenfalls vollflächig aufgetragene Emitterschicht nur an den Stellen Licht emittiert, die mit leitfähigem Polymer beschichtet sind. Nach diesem Verfahren ist es auf einfache Weise ohne Strukturierung der leitfähigen Basiselektrode z.B. durch Ätzprozesse möglich, strukturierte Elektrolumineszensanzeigen herzustellen. Die Dicke der lochinjizierenden Schicht (3) beträgt etwa 3 bis 500 nm, bevorzugt 10 bis 200 nm.

Auf die lochinjizierende Schicht (3) werden anschließend die weiteren Schichten aus Lösung oder durch Aufdampfen aufgebracht. Bevorzugt werden hierbei als Emitter-schicht 5 Polyparaphenylenvinylenderivate und/oder Polyfluorenderivate ohne zusätzliche lochtransportierende Schicht 4 oder Aluminiumkomplexe wie Aluminiumchinolat in Verbindung mit einer lochtransportierenden Zwischenschicht 4 verwendet.

Die Funktion der lochinjizierenden Zwischenschicht kann in einem speziellen Aufbau (siehe auch Synth. Met. 111 (2000) 139) getestet werden. Dazu wird die lochinjizierende Zwischenschicht auf nasschemisch gereinigtes ITO-Substrat mittels Spin-Coater aufgebracht. Anschließend wird die Schicht bei 120°C für 5 min getempert. Die Schichtdicke beträgt 60 nm. Danach wird eine 1,5 %-Gew. Tetrahydrofuran-Lösung des Lochtransportmoleküls 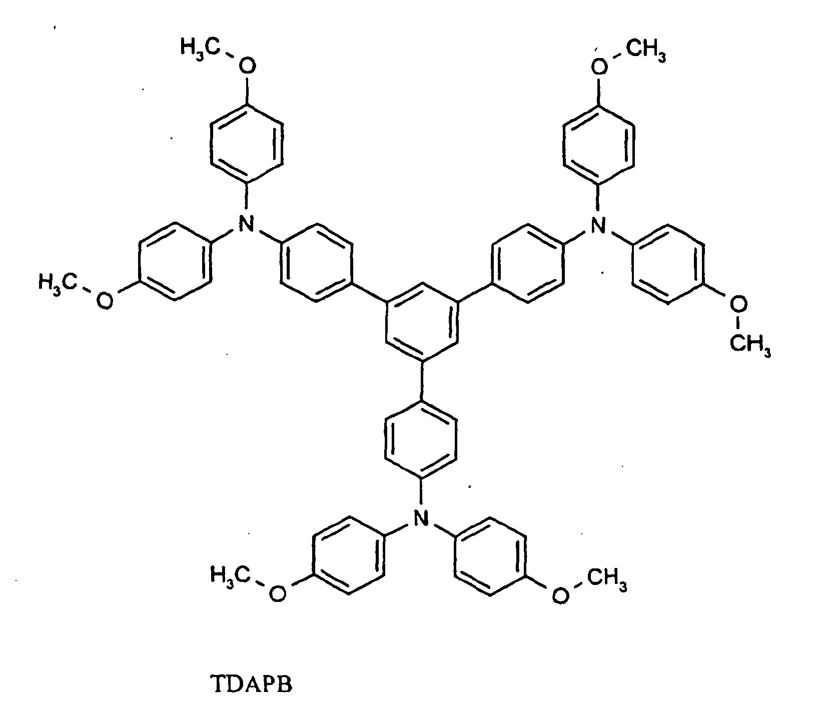 aufgeschleudert. Die Gesamt-Schichtdicke beträgt nun 160 nm. Als Emitter-Schicht wird Aluminiumchinolat (Alq) als 60 nm dicke Schicht aufgedampft. Als Kathode wird abschließend eine Legierung aus Mg und Ag aufgedampft. Durch Kontaktierung der Indiumzinnoxid(ITO)-Anode und der Metall-Kathode werden mittels eines Kennlinienschreibers und einer kalibrierten Photodiode Strom-Spannungs-Leuchtdichte-Kennlinien aufgenommen.

Die erfindungsgemäß hergestellten organischen Leuchtdioden zeichnen sich durch hohe Lebensdauer, hohe Leuchtstärke, niedrige Einsatzspannungen und ein hohes Gleichrichtungsverhältnis aus.

### Beispiele

### Beispiel 1

1 Liter einer 1,4 gew.-%igen 3,4-Polyethylendioxythiophen/Polystyrolsulfonat-Dispersion mit einem Gewichtsverhältnis des 3,4-Polyethylendioxythiophens zu Polystyrolsulfonsäure von 1:8 hergestellt durch Einengen einer 3,4-Polyethylendioxythiophen/Polystyrolsulfonat-Dispersion nach Beispiel 2 aus EP-A 991 303 wurde zweimal mit einem Hochdruckhomogenisator bei 700 bar und einem Düsendurchmesser von 0,1 mm homogenisiert.

Anschließend wurden mittels Spin Coating Beschichtungen auf Glasplatten hergestellt, bei 120°C getrocknet und der spezifische Widerstand der Schichten im Vakuum bei ca.10⁻⁶ mbar bestimmt.

Die Anwendung dieser lochinjizierenden Zwischenschicht A in organischen Leuchtdioden wurde anschließend in einem Aufbau bestehend aus folgendem Mehrschichtstapel überprüft:
ITO//Schicht A (60 nm)//TDAPB(100 nm)//Alq(60 nm)//MgAg.

### Beispiel 2

1700 g einer 1,4 gew.-%igen 3,4-Polyethylendioxythiophen/Polystyrolsulfonat-Lösung hergestellt durch Einengen einer 3,4-Polyethylendioxythiophen/Polystyrolsulfonat-Dispersion nach Beispiel 2 aus EP-A 991 303 mit einem Gewichtsverhältnis des 3,4-Polyethylendioxythiophens zu Polystyrolsulfonsäure von 1:8 wurde unter Rühren mit 659,4 g einer 4,8 gew.-%igen wässrigen Polystyrolsulfonsäurelösung versetzt, so dass das Gewichtsverhältnis von 3,4-Polyethylendioxythiophen zu Polystyrolsulfonat in der Lösung 1:20 ist. Die so erhaltene Lösung wurde 4 mal mit einem Hochdruckhomogenisator bei 400 bar und 0,2 mm Düsendurchmesser homogenisiert.

Anschließend wurden mittels Spin Coating Beschichtungen auf Glasplatten hergestellt, bei 120°C getrocknet und der spezifische Widerstand der Schichten im Vakuum bei ca. 10⁻⁶ mbar bestimmt.

Die Anwendung dieser lochinjizierenden Zwischenschicht B in organischen Leuchtdioden wurde anschließend in einem Aufbau bestehend aus folgenden Mehrschichtstapel überprüft:
ITO//Schicht B (60 nm)//TDAPB(100 nm)//Alq(60 nm)//MgAg.

### Beispiel 3

2000 g einer 1,4 gew.-%igen 3,4-Polyethylendioxythiophen/Polystyrolsulfonat-Lösung hergestellt durch Einengen einer 3,4-Polyethylendioxythiophen/Polystyrolsulfonat-Dispersion nach Beispiel 2 aus EP-A 991 303 mit einem Gewichtsverhältnis des 3,4-Polyethylendioxythiophens zu Polystyrolsulfonsäure von 1:8 wurde unter Rühren mit 259 g einer 4,8 gew.-%igen wässrigen Polystyrolsulfonsäurelösung versetzt, so dass das Gewichtsverhältnis von 3,4-Polyethylendioxythiophen zu Polystyrolsulfonat in der Lösung 1:12 ist. Die so erhaltene Lösung wurde 4 mal mit einem Hochdruckhomogenisator bei 400 bar und einem Düsendurchmesser von 0,2 mm homogenisiert.

Anschließend wurden mittels Spin Coating Beschichtungen auf Glasplatten hergestellt, bei 120°C getrocknet und der spezifische Widerstand der Schichten im Vakuum bei ca.10⁻⁶ mbar bestimmt.

Die Anwendung dieser lochinjizierenden Zwischenschicht C in organischen Leuchtdioden wurde anschließend in einem Aufbau bestehend aus folgenden Mehrschichtstapel überprüft:
ITO//Schicht C (60 nm)//TDAPB(100 nm)//Alq(60 nm)//MgAg.

Die erhaltenen Ergebnisse sind in der folgenden Tabelle zusammengefasst:

**Tabelle**

| Beispiel | 90 % der Teilchen in der Dispersion im gequollenen Zustand < x nm | spezifischer Widerstand [Ωcm] | Effizienz @5V [cd/A] | Lebensdauer-Halbwertszeit @8 mA/cm² [h] |
|---|---|---|---|---|
| Beispiel 2 aus EP-A 991 303 (Vergleich) | 72 | 980 | 1,47 | 650 |
| 1 | 35 | 8300 | 1,47 | 650 |
| 2 | 34 | 101000 | 1,50 | 600 |
| 3 | 35 | 37000 | 1,45 | 700 |

| | | | | |
|---|---|---|---|---|
| Effizienz = Leuchtstärke der Elektrolumineszenzanzeige in Candela/Ampere gemessen bei einer angelegten Spannung von 5 Volt. Lebensdauer = Zeit in Stunden bis die Leuchtstärke der Elektrolumineszenzanzeigen bei konstantem Strom von 8 mA/cm² auf die Hälfte abgesunken ist. | | | | |

Es wird deutlich, dass der zur Vermeidung des Cross Talks benachbarter Linien erhöhte Widerstand der Zwischenschichten (Beispiel 1-3) keinen negativen Effekt auf die Effizienz und Lebensdauer der Leuchtdioden hat.

## Patentansprüche

1. Dispersionen enthaltend Polyanionen und kationische 3,4-Polyalkylendioxythiophene, **dadurch gekennzeichnet, dass** mindestens 90 Gew.% der Teilchen der Dispersion <50 nm sind.

2. Dispersionen nach Anspruch 1, in denen mindestens 90 % der Teilchen <40 nm sind.

3. Dispersionen nach Anspruch 1, **dadurch gekennzeichnet, dass** der spezifische Widerstand von daraus hergestellten Beschichtungen >5000Ωcm ist.

4. Dispersionen nach Anspruch 1, **dadurch gekennzeichnet, dass** es sich bei den 3,4-Polyalkylendioxythiophenen um Verbindungen der Formel (1) 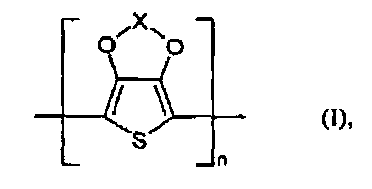 in der
n für eine ganze Zahl von 3 bis 100 , bevorzugt 4 bis 15 und
X für -(CH₂)ₓ-CR¹R²-(CH₂)_{y}- steht, wobei
R¹, R² unabhängig voneinander für H, einen gegebenenfalls substituierten Alkylrest mit 1 bis 20 C-Atomen, einen Arylrest mit 6 bis 14 C-Atomen oder -CH₂-OR³ mit R³ = H, Alkyl oder -CH₂-CH₂-CH₂- SO₃H und
x, y jeweils unabhängig voneinander für eine ganze Zahl von 0 bis 9 steht,
handelt.

5. Dispersionen nach Anspruch 1, **dadurch gekennzeichnet, dass** es sich um 3,4-Polyethylendioxythiophen/Polystyrolsulfonat-Dispersionen handelt.

6. Dispersionen nach Anspruch 1, **dadurch gekennzeichnet, dass** das Verhältnis von kationischem 3,4-Polyalkylendioxythiophen zu Polyanion zwischen 1:8 und 1:25 liegt.

7. Elektrolumineszierende Anordnung, enthaltend eine lochinjizierende Schicht, **dadurch gekennzeichnet, dass** die lochinjizierende Schicht aus einer Dispersion gemäß Anspruch 1 hergestellt wurde.

8. Elektrolumineszierende Anordnung nach Anspruch 7, **dadurch gekennzeichnet, dass** als lichtemittierende Schicht Polyfluorene und/oder Polyparaphenylenvinylene verwendet werden.

## Claims

1. Dispersions comprising polyanions and cationic 3,4-polyalkylenedioxythiophenes, **characterized in that** at least 90 per cent by weight of the particles of the dispersion are < 50 nm.

2. Dispersions according to Claim 1, in which at least 90 per cent by weight of the particles are < 40 nm.

3. Dispersions according to Claim 1, **characterized in that** the resistivity of coatings produced therefrom is > 5000 Ωcm.

4. Dispersions according to Claim 1, **characterized in that** the 3,4-polyalkylenedioxythiophenes are compounds of the formula (I) 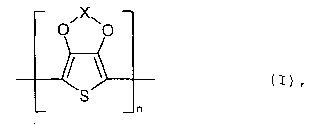 in which
n is an integer from 3 to 100, preferably from 4 to 15, and
X is -(CH₂)ₓ-CR¹R²-(CH₂)_{y}-, where
R¹ and R², independently of one another, are H, an optionally substituted alkyl radical having from 1 to 20 carbon atoms, an aryl radical having from 6 to 14 carbon atoms or -CH₂-OR³, where R³ - H, alkyl or -CH₂-CH₂-CH₂-SO₃H, and
x and y are each, independently of one another, an integer from U to 9.

5. Dispersions according to Claim 1, **characterized in that** they are 3,4-polyethylenedioxy-thiophene/polystyrene sulphonate dispersions.

6. Dispersions according to Claim 1, **characterized in that** the weight ratio of cationic 3,4-poly-alkylenedioxythiophene to polyanion is between 1:8 and 1:25.

7. Electroluminescent arrangement containing a hole-injecting layer, **characterized in that** the hole-injecting layer has been produced from a dispersion according to Claim 1.

8. Electroluminescent arrangement according to Claim 7, **characterized in that** polyfluorenes and/or poly-para-phenylenevinylenes are used as light-emitting layer.

## Revendications

1. Dispersions contenant des polyanions et des 3,4-polyalkylènedioxythiophènes cationiques, **caractérisées en ce qu'**au moins 90 % en poids des particules de la dispersion ont une taille < 50 nm.

2. Dispersions selon la revendication 1, dans lesquelles au moins 90 % en poids des particules ont une taille < 40 nm.

3. Dispersions selon la revendication 1, **caractérisées en ce que** la résistance spécifique des revêtements produits à partir de celles-ci est > 5 000 Ωcm.

4. Dispersions selon la revendication 1, **caractérisées en ce que** les 3,4-polyalkylène-dioxythiophènes consistent en des composés de formule (I) 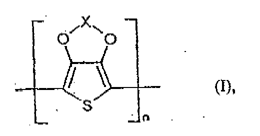 dans laquelle
n représente un nombre entier allant de 3 à 100, de préférence de 4 à 15 et
X représente un groupe - (CH₂)ₓ-CR¹R²-(CH₂)_{y}-, où
R¹, R² représentent, indépendamment l'un de l'autre, H, un radical alkyle éventuellement substitué ayant de 1 à 20 atomes de carbone, un radical aryle ayant de 6 à 14 atomes de carbone ou -CH₂-OR³, où R³ = H, alkyle ou - CH₂-CH₂-CH₂-SO₃H et
x, y représentent chacun, indépendamment l'un de l'autre, un nombre entier allant de 0 à 9.

5. Dispersions selon la a revendication 1, **caractérisées en ce qu'**il s'agit de dispersions de 3,4-polyéthylènedioxythiophène/polystyrène-sulfonate.

6. Dispersions selon la revendication 1, **caractérisées en ce que** le rapport pondéral du 3,4-polyalkylènedioxythiophène au polyanions est compris entre 1:8 et 1:25.

7. Dispositif électroluminescent, contenant une couche injectrice de trous, **caractérisé en ce que** la couche injectrice de trous a été produite à partir d'une dispersion selon la revendication 1.

8. Dispositif électroluminescent selon la revendication 7, **caractérisé en ce qu'**on utilise comme couche photo-émettrice des polyfluorènes et/ou des polyparaphénylène-vinylènes.
